# EUROPEAN PATENT APPLICATION

(11) **EP 2 720 279 A2**
(43) Date of publication of application: **16.04.2014**
(21) Application number: 12800914.9
(22) Date of filing: 08.06.2012
(51) Int. Cl.: H01L 31/042, H01L 31/0224

(54) **SOLAR CELL SUBSTRATE AND SOLAR CELL USING SAME**

(30) Priority: 13.06.2011 KR 20110057108; 13.06.2011 KR 20110057116
(71) Applicant: POSCO, Kyungsangbook-do 790-300 (KR)
(72) Inventor: KIM, Kyoung-Bo, Gwangyang-si Jeollanam-do 545-711 (KR); PARK, Young-Jun, Gwangyang-si Jeollanam-do 545-711 (KR); BAEK, Je-Hoon, Gwangyang-si Jeollanam-do 545-711 (KR); KIM, Jong-Sang, Gwangyang-si Jeollanam-do 545-711 (KR)
(74) Representative: Powell, Timothy John
(86) International application number: PCT/KR2012/004573
(87) International publication number: WO 2012/173360

(57) **Abstract**

The present invention relates to a solar cell substrate, and to a solar cell using same. The solar cell according to one embodiment of the present invention comprises: a lower substrate; and a lower electrode formed on the lower substrate. The lower electrode is formed of a Mo-X-Na three-component-system compound metal layer. Here, X may be one of Nb, Ni, Si, Ti, W, and Cr. The solar cell according to another embodiment of the present invention may comprise: a solar cell substrate including a lower substrate and a Mo-X-Na three-component-system compound metal layer that is a lower electrode formed on the lower substrate; a light-absorption layer formed on the solar cell substrate; a buffer layer formed on the light-absorption layer; a transparent window formed on the buffer layer; and an upper electrode formed on the transparent window.

## Description

### [Technical Field]

Aspects of embodiments relate to a CI (G) S solar cell substrate and a solar cell.

### [Background Art]

Due to the influence of global warming, fuel resource depletion, environmental pollution, and others, a traditional energy-collecting method of collecting energy stored in fossil fuels is slowly reaching its limits. In particular, although predicted remaining quantities of petroleum are slightly different from each other, depending on concerned predictors, the prevailing forecast is that global petroleum reserves will be depleted within a relatively short period of time.

Further, according to the convention on energy use and climate change, represented by the Kyoto Protocol, it is compulsorily required that the generation of carbon dioxide produced by the combustion of fossil fuels should be decreased. Therefore, it is clear that the continued use of fossil fuels will have effect on all countries of the world, as well as current treaty powers, so that going into the future; restrictions will be set on annual consumption amounts of fossil fuels.

Representative energy sources used as substitutes for fossil fuels may include nuclear power generation. Nuclear power generation has been in the spotlight as an influential alternative energy source which can replace fossil fuels such as petroleum and others and is available in an almost infinite quantity, since the amount of energy that can be collected per unit weight of uranium or plutonium as a raw material is large, and greenhouse gases such as carbon dioxide and others are not generated in the case of nuclear power generation.

However, nuclear meltdowns such as that which occurred at a nuclear power plant in Chernobyl in the former Soviet Union or the meltdowns which occurred at the Fukushima nuclear power plant in Japan due to the Great East Japan Earthquake (the 2011 To̅haku Earthquake) have served to build momentum for reexamining the safety of nuclear power generation, a source of power that had been regarded, in some quarters, as a potentially clean energy source available in an infinite quantity. As a result thereof, it is more urgently needed than ever to introduce alternative sources of energy, other than nuclear power.

Although certain alternative energy sources, such as hydroelectric power, have often been as touted as alternatives to fossil fuels, their uses may be limited due to practical concerns, in the case of hydroelectric power, topographical and climatic factors. Further, it is also difficult to use alternative energy sources as alternatives to fossil fuels, due to the fact that alternative energy sources generate relatively small amounts of power, or have greatly limited areas of application.

However, solar cells have advantages in that it is possible to produce electric power by installing solar cell panels on small rooftops and other building areas when solar cells are provided in answer to demand for low capacity solar cells for household use, since such solar cells are not only usable anywhere, but are also almost linearly proportional to each other in terms of electric power generating capacity and facility scale, if a proper amount of sunshine is guaranteed. Therefore, the use of the solar cells has increased all over the world, and studies related to solar cells have also increased.

In solar cells using the principle of semiconductors, electron hole pairs (EHP) are produced by irradiating light having at least a certain level of energy onto p-n junction semiconductors such that valence electrons in the semiconductors are excited to be freely movable valence electrons. The electron hole pairs thusly produced are moved to electrodes that are placed opposite to each other to generate electromotive force.

The most basic form of the solar cell is a silicon-based solar cell, commonly known as a first generation solar cell, wherein the silicon-based solar cell is formed by doping an impurity B on a silicon substrate to form a p-type semiconductor, doping another impurity P on a p-type semiconductor to form a layer, and forming a part of the layer into an n-type semiconductor such that a p-n junction is performed.

Such a silicon-based solar cell has seen the highest degree of commercialization, due to its relatively high energy conversion efficiency and cell conversion efficiency (a ratio of conversion efficiency during mass-production to the highest energy conversion efficiency in the laboratory). However, there is a problem, in that in the manufacturing thereof, material consumption is relatively high, resulting in high manufacturing costs, since in the manufacturing of a module for the silicon-based solar cell, such a module not only passes through somewhat complicated process steps of first manufacturing an ingot from a particular material, forming the ingot into a wafer to manufacture cells and modualizing the cells, but also includes using a bulk-type material.

In order to resolve such shortcomings of such a first generation silicon-based solar cell, a so-called thin film type solar cell, commonly known as a second generation solar cell, has been suggested. Such a thin film type solar cell has an advantage in that material costs in the manufacturing thereof are relatively inexpensive due to a simple manufacturing process and the relative thinness of the thin film type solar cell, since the solar cell is not manufactured by the above-mentioned process, but it is manufactured in such a form that required thin film layers are subsequently layered on the substrate.

There are many obstacles to the commercialization of such a thin film type solar cell, since it does not yet have a high degree of energy conversion efficiency, as compared to existing silicon-based solar cells, in numerous cases. However, some thin film type solar cells having high energy conversion efficiency have been developed and are in the process of being commercialized.

The thin film type solar cell may include a (CI (G) S) -based solar cell as an example, wherein the solar cell is based on a CI (G) S compound semiconductor including copper (Cu), indium (In), germanium (Ge), and selenium (Se), wherein the solar cell may not include germanium, and the solar cell may be known as a CIS compound semiconductor if germanium is not contained in the solar cell.

The semiconductor has an advantage in that energy conversion efficiency can be increased by controlling contents of the elements, such that bandwidth gaps can be controlled, since the semiconductor includes three or four elements. Here, sulfur (S) may be substituted for selenium (Se) or selenium (Se) may be used together with sulfur (S). Such solar cells are regarded as CI(G)S solar cells in both cases.

A copper indium gallium selenium (CIGS) solar cell including germanium has a substrate existing in the lowermost layer thereof, and a lower electrode used as an electrode is formed on the substrate. A light absorption layer, e.g., CIGS as a p-type semiconductor, a buffer layer, e.g., CdS as an n-type semiconductor, a transparent window, and an upper electrode are subsequently formed on the lower electrode.

According to the related art, glass has mainly been used as a material forming the substrate for a CI(G)S solar cell, and a metal electrode formed of molybdenum (Mo) has mainly been used as a lower electrode. Glass has been known to play a role in improving solar cell properties, due to sodium (Na) included in glass in a case in which the glass substrate, as above, is used. For example, when Na is added to a CI(G)S thin film to be diffused therein, a charge concentration is increased such that open circuit voltage and fidelity of the solar cell may be improved.

A number of attempts have recently been made to use a flexible substrate instead of a relatively expensive glass substrate which may be relatively difficult to mass-produce, and may only be usable in a standardized form. The flexible substrate may be usable in diverse applications, such as in Building Integrated Photovoltaics (BIPV) and aerospace solar cells, since the flexible substrate is more inexpensive than glass, the solar cell may be manufactured from the flexible substrate by a roll to roll process, and the flexible substrate may be formed in various manners. Examples of such flexible substrates may mainly include metal sheets or plastic-based substrates such as stainless steel, aluminum foil, and polyimide films.

In cases of such flexible substrates, since there is no effect obtainable by adding sodium (Na) thereto, attempts to solve the problem as outlined above by forming a molybdenum (Mo) - sodium (Na) layer containing Na in a lower electrode 30 interposed between a lower substrate 10 and a CI (G) S layer 40 have been made. However, a problem related to adhesion between a lower electrode and a metal substrate and corrosion resistance thereof has remained.

### [Disclosure]

### [Technical Problem]

An aspect of an embodiment may provide a solar cell substrate and a solar cell having improved adhesion between a lower electrode and a lower substrate and corrosion resistance of a lower electrode.

### [Technical Solution]

According to an aspect of an embodiment, a solar cell substrate may include: a lower substrate and a lower electrode formed on the lower substrate, the lower electrode being formed of a molybdenum (Mo) - X - sodium (Na) three-component system composite metal layer, wherein X is at least one selected from niobium (Nb), nickel (Ni), silicon (Si), titanium (Ti), tungsten (W), and chromium (Cr). The lower electrode may further include a molybdenum(Mo) layer formed on the Mo-X-Na three-component system composite metal layer. The lower substrate and the Mo-X-Na three-component system composite metal layer may include a multilayer metal diffusion barrier layer interposed therebetween and formed of at least two layers of which layers adjacent to each other are formed of different types of metal. The multilayer metal diffusion barrier layer may include an oxide layer interposed between metal layers thereof.

According to an aspect of an embodiment, a solar cell may include: a solar cell substrate including a lower substrate and a lower electrode, a molybdenum (Mo) - X- sodium (Na) three-component system composite metal layer, formed on the lower substrate; a light absorption layer formed on the solar cell substrate; a buffer layer formed on the light absorption layer; a transparent window formed on the buffer layer; and an upper electrode formed on the transparent window. The lower electrode may further include a Mo layer formed on the Mo-X-Na three-component system composite metal layer. The lower substrate and the lower electrode may include a multilayer metal diffusion barrier layer interposed therebetween and formed of at least two layers of which layers adjacent to each other are formed of different types of metal. The multilayer metal diffusion barrier layer may include an oxide layer interposed between metal layers thereof.

### [Advantageous Effects]

According to an embodiment, a solar cell substrate including a lower electrode having improved adhesion and corrosion resistance, as compared to a Mo-Na compound or a Mo-X-Na -type lower electrode according to the related art, may be provided, and a solar cell having improved durability and stable qualities may be provided.

### [Description of Drawings]

The above and other aspects, features and other advantages will be more clearly understood from the following detailed description taken in conjunction with the accompanying drawings, in which:

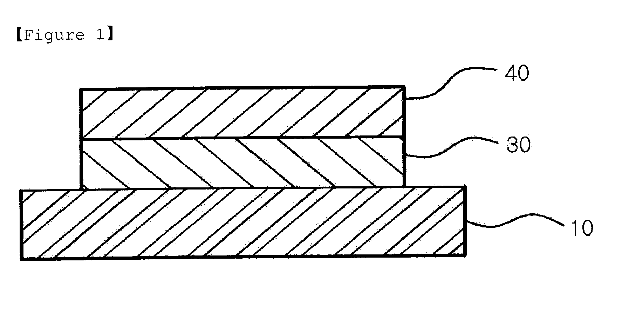

FIG. 1 is a cross-sectional view of a lower electrode formed of a molybdenum (Mo) - sodium (Na) alloy according to the related art;
FIG. 2 is a cross-sectional view of a lower electrode formed of a Mo-X-Na three-component system composite metal layer according to an embodiment of the inventive concept; and
FIG. 3 is a cross-sectional view illustrating a Mo/Mo-X-Na multilayer lower electrode, a multilayer diffusion barrier layer and a lower substrate according to an embodiment of the inventive concept.

### [Best Mode for Invention]

Hereinafter, embodiments will be described in detail with reference to the accompanying drawings.

Embodiments may, however, be embodied in many different forms and should not be construed as being limited to embodiments set forth herein. Rather, these embodiments are provided so that this disclosure will be thorough and complete, and will fully convey the scope of the inventive concept to those skilled in the art. In the drawings, the shapes and dimensions of elements may be exaggerated for clarity.

The inventive concept is provided by considering that a lower electrode stacked on a flexible substrate is manufactured as a composite metal electrode including sodium (Na) through detailed research into a scheme capable of improving adhesion between a substrate and a lower electrode and corrosion resistance thereof, as well as improving performance of a solar cell, such that improvements of adhesion between a substrate and a lower electrode and corrosion resistance may be realized.

First, a solar cell substrate according to an embodiment will be described in detail. According to an embodiment, a substrate may include a lower substrate, a lower electrode stacked on the lower substrate, and a diffusion barrier layer.

Here, the substrate may be a flexible substrate, and the flexible substrate may be formed of, for example, stainless steel, aluminum foil, an iron (Fe) - nickel (Ni) alloy, an iron (Fe) - copper (Cu) alloy, a polyimide-based material, or the like.

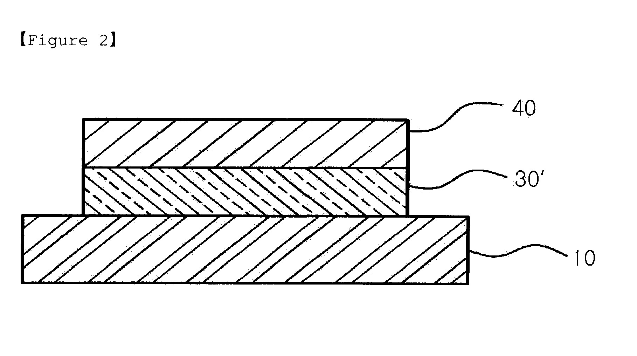

According to an embodiment, the lower electrode may be a Mo-X-Na three-component system composite metal layer. As shown in FIG. 2, a lower electrode 30' formed between a lower substrate 10 and a copper indium gallium selenium (CI (G) S) layer 40 may be formed as a Mo-X-Na three-component system composite metal layer.

In addition, according to an embodiment, the lower electrode may include a molybdenum (Mo) layer and a Mo-X-Na three-component system composite metal layer. In this case, the Mo-X-Na three-component system composite metal layer may be stacked on the lower substrate, and the Mo layer may be formed on the Mo-X-Na three-component system composite metal layer.

X included in the Mo-X-Na three-component system composite metal layer may be niobium (Nb), nickel (Ni), silicon (Si), titanium (Ti), tungsten (W), chromium (Cr) or the like. In X, W having a density greater than that of Mo may be used to significantly increase effects of improvements in corrosion resistance. By including X therein, adhesion with the diffusion barrier layer to be described below and corrosion resistance thereof may be further improved as compared to a case in which an electrode formed only of Mo is used, and by including Na therein, the density of holes may be increased to improve an open-circuit voltage of a solar cell.

X applied to the Mo-X-Na three-component system composite metal layer may be elements described above, but when the diffusion barrier layer is interposed between the Mo-X-Na three-component system composite metal layer and the substrate, X may be an element the same as that forming the diffusion barrier layer. When both elements are identical to each other as described above, adhesion between the lower electrode and the substrate may be further increased. In addition, when the diffusion barrier layer is not formed of a single layer, but is formed of two or more layers stacked on each other, an element forming the uppermost layer of the diffusion barrier layer may be the same as that of X of the Mo-X-Na three-component system composite metal layer.

In the Mo-X-Na three-component system composite metal layer, an upper limit of the content of molybdenum (Mo) may be 50 weight%, and remaining elements may be X and sodium (Na). When the content of Mo exceeds 50 weight%, since the content of X is relatively low, as compared to that of Mo, an effect obtained from the introduction of X, corrosion resistance, may not be improved, and adhesion obtained thereby may be deteriorated. However, the contents of Na and X according to an embodiment of the inventive concept may not be particularly limited.

A thickness of the lower electrode may be 1µm or less. In this case, the lower electrode may include the Mo-X-Na three-component system composite metal layer, or may include a Mo layer and the Mo-X-Na three-component system composite metal layer (which may be referred to as Mo/Mo-X-Na). When the lower electrode is controlled to have a thickness of 1µm or less, the lower electrode may be suitable to be used as a thin film, a lower electrode for a CI(G)S solar cell, proposed according to an embodiment of the inventive concept.

In addition, when the lower electrode includes both of the Mo layer and the Mo-X-Na three-component system composite metal layer, a ratio of a thickness of the Mo layer to a thickness of the Mo-X-Na three-component system composite metal layer may be within a range of 1: 0.5 to 1.5. In detail, a ratio of a thickness of the Mo layer to a thickness of the Mo-X-Na three-component system composite metal layer may be 1:1.

In addition, a diffusion barrier layer including at least two metal layers may be interposed between the lower substrate and the lower electrode. In addition, in the case of the diffusion barrier layer, adjacent layers of the diffusion barrier layer may be formed of different types of metal. In further detail, the diffusion barrier layer may be formed of three metal layers. Interfaces thereof formed between different types of material may serve as a barrier preventing different elements such as impurities or the like from being diffused. When the different elements diffused in a single material meet a new material, the diffusion thereof may be blocked by the barrier due to a difference in diffusion behaviors between the new material and an the existing material. A structure of the multilayer diffusion barrier layer may suppress the diffusion of impurities through the barrier effects described as above, more effectively.

A total thickness of the diffusion barrier layer according to the embodiment may be controlled to be within a range of 100 to 1500nm. When the total thickness is less than 100nm, difficulties in that the diffusion prevention effects provided according to an embodiment of the inventive concept are obtained may be present. In addition, when the total thickness of the diffusion barrier layer exceeds 1500nm, adhesion between the substrate and the lower electrode may be deteriorated.

In addition, even when the diffusion barrier layer is formed to have the same thickness as that of a single layer, a significantly excellent diffusion prevention effect may be secured, as compared to the case of the single layer, through a diffusion prevention effect using the metal layer interface. For example, in comparing a diffusion barrier layer formed of a single layer having a thickness of 150nm to a multilayer diffusion barrier layer configured of three layers having respective thicknesses of 50nm, since the multilayer diffusion barrier layer further includes two or more interfaces as compared to that of the single-layer diffusion barrier layer, a further excellent diffusion prevention effect may be obtained by the multilayer diffusion barrier layer at the same thickness as that of a diffusion barrier layer, configured of a single layer.

The metal layer having two or more layers may be formed to include different metals therein. In further detail, a metal layer configured of two or more layers may be formed such that surfaces of the metal layers contacting with each other may be formed of different materials. As the metal layer, one of niobium (Nb), nickel (Ni), silicon (Si), titanium (Ti), tungsten (W), and chromium (Cr) may be used. A respective metal layer thereof may have a thickness of 10nm.

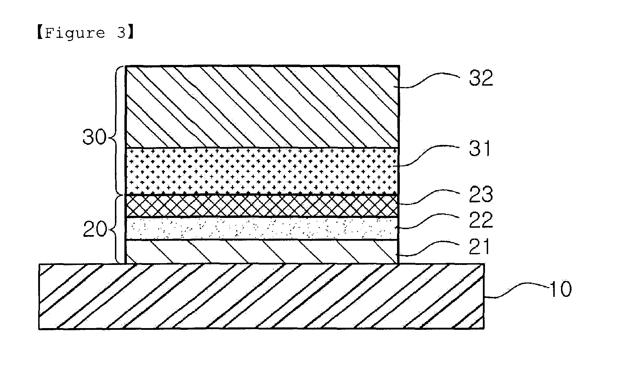

An embodiment according to the description above may be carried out with reference to FIG. 3. FIG. 3 is a cross-sectional view illustrating a lower electrode, a diffusion barrier layer and a lower substrate according to an embodiment of the inventive concept. A diffusion barrier layer 20 configured of three layers 21, 22 and 23 may be formed on a lower substrate 10, and a lower electrode 30 configured of a Mo-X-Na three-component system composite metal layer 31 and a molybdenum (Mo) layer 32 may be formed on the diffusion barrier layer 20.

In addition, the multilayer metal diffusion barrier layer may include an oxide layer between metal layers therein. The oxide layer may include one of SiO_{X}, SiN_{X}, and Al₂O₃. Further, a thickness of the oxide layer may be 10nm or more. In the case of a ceramic material, the diffusion of different elements may not be easily performed as compared to a metal or the like, and thus, a diffusion prevention effect may be improved.

Hereinafter, a method of manufacturing a CI (G) S solar cell substrate according to an embodiment will be described in detail. Here, first, a substrate may be prepared. The substrate may be one selected from a group consisting of stainless steel, aluminum foil, an iron (Fe) - nickel (Ni) alloy, iron (Fe) - copper (Cu) alloy and a polyimide-based material, as described above.

In addition, a Mo-X-Na three-component system composite metal may be prepared as a target material. Further, molybdenum (Mo), X, and sodium (Na) may be respectively prepared as target materials. As X, Nb, Ni, Si, Ti, W, Cr or the like may be used as described above, and in detail, W may be used.

The target material may be deposited on the lower substrate using a sputtering method. The sputtering method may be performed using cobalt (Co)-sputtering. For example, as the target material, Mo, X and Na, may be sputtered once. In addition, Mo and X may be formed to be stacked on each other, as the target materials, and Na may then be doped. Further, elements may also be stacked to be formed as respective layers, using a sputtering method, to then be subjected to a heat treatment, such that the composite metal layer described above may be formed. After a Mo-X-Na layer is stacked on the lower substrate, a Mo layer may be additionally stacked thereon. In this case, the Mo layer may be deposited on the Mo-X-Na three-component system composite metal layer using the sputtering method, such that a multilayer lower electrode may be formed.

Here, when the diffusion barrier layer or the oxide layer is formed, the respective layers may be stacked sequentially, based on requirements according to an embodiment of the inventive concept. In this case, as a stacking method, a sputtering method may be used, but the stacking method is not particularly limited and any method may be used, as long as the method is able to allow the metal layer or the oxide layer to be stacked so as to be suitable for the requirements according to an embodiment of the inventive concept.

Hereinafter, a solar cell according to an embodiment will be described in detail.

The CI (G) S solar cell may include a solar cell substrate including a lower substrate and a lower electrode, a Mo-X-Na three-component system composite metal layer, formed on the lower substrate, a light absorption layer formed on the solar cell substrate, a buffer layer formed on the light absorption layer, a transparent window formed on the buffer layer, and an upper electrode formed on the transparent window. Materials forming the light absorption layer, the buffer layer, the transparent layer, and the like, may be different according to a solar cell type to be implemented. As an example, in the CIGS solar cell, the light absorption layer may be formed of CIGS, the buffer layer, an N-type semiconductor, may be formed of CdS, and the transparent window may be formed of zinc oxide (ZnO).

In this case, the lower electrode may further include a Mo layer formed on the Mo-X-Na three-component system composite metal layer. The lower electrode may be characterized by the same characteristics as those described with respect to the solar cell substrate.

In addition, at least two layers interposed between the lower substrate and the lower electrode and contacting with each other may include a multilayer metal diffusion barrier layer formed of different types of metal. The multilayer metal diffusion barrier layer may be characterized by the same characteristics as those described with respect to the solar cell substrate.

The multilayer metal diffusion barrier layer may include an oxide layer interposed between the metal layers. The oxide layer may be characterized by the same characteristics as those described with respect to the solar cell substrate.

While the inventive concept has been shown and described in connection with the embodiments, it will be apparent to those skilled in the art that modifications and variations can be made without departing from the spirit and scope of the inventive concept as defined by the appended claims.

## Claims

1. A solar cell substrate comprising:
a lower substrate and a lower electrode formed on the lower substrate, the lower electrode being formed of a molybdenum (Mo) - X - sodium (Na) three-component system composite metal layer,
wherein X is at least one selected from niobium (Nb), nickel (Ni), silicon (Si), titanium (Ti), tungsten (W), and chromium (Cr).

2. The solar cell substrate of claim 1, wherein the lower electrode further includes a molybdenum (Mo) layer formed on the Mo-X-Na three-component system composite metal layer.

3. The solar cell substrate of claim 1, wherein the lower substrate and the Mo-X-Na three-component system composite metal layer include a multilayer metal diffusion barrier layer interposed therebetween and formed of at least two layers of which layers adjacent to each other are formed of different types of metal.

4. The solar cell substrate of claim 3, wherein the multilayer metal diffusion barrier layer includes an oxide layer interposed between metal layers thereof.

5. The solar cell substrate of claim 1, wherein the lower substrate is formed of one selected from a group consisting of stainless steel, aluminum foil, an iron (Fe) - nickel (Ni) alloy, an iron (Fe) - copper (Cu) alloy, and a polyimide-based material.

6. The solar cell substrate of claim 1, wherein the Mo-X-Na three-component system composite metal layer has a content of molybdenum (Mo) of 50 weight% or less.

7. The solar cell substrate of claim 1, wherein the lower electrode has a thickness of 1µm or less.

8. The solar cell substrate of claim 2, wherein a ratio of a thickness of the Mo layer to a thickness of the Mo-X-Na three-component system composite metal layer is within a range of 1: 0.5 to 1.5.

9. The solar cell substrate of claim 3, wherein the multilayer metal diffusion barrier layer has a thickness of 100 to 1500nm.

10. A solar cell comprising:
a solar cell substrate including a lower substrate and a lower electrode, a molybdenum (Mo) - X- sodium (Na) three-component system composite metal layer, formed on the lower substrate;
a light absorption layer formed on the solar cell substrate;
a buffer layer formed on the light absorption layer;
a transparent window formed on the buffer layer; and
an upper electrode formed on the transparent window.

11. The solar cell of claim 10, wherein the lower electrode further includes a Mo layer formed on the Mo-X- Na three-component system composite metal layer.

12. The solar cell of claim 10, wherein the lower substrate and the lower electrode include a multilayer metal diffusion barrier layer interposed therebetween and formed of at least two layers of which layers adjacent to each other are formed of different types of metal.

13. The solar cell of claim 12, wherein the multilayer metal diffusion barrier layer includes an oxide layer interposed between metal layers thereof.
